# EUROPEAN PATENT APPLICATION

(11) **EP 4 268 931 A1**
(43) Date of publication of application: **01.11.2023**
(21) Application number: 21913731.2
(22) Date of filing: 02.12.2021
(51) Int. Cl.: B01D 53/00, B01D 53/02, B01D 46/00, B01D 46/30, C23C 16/44

(54) **EXHAUST GAS FILTERING APPARATUS AND COATING EQUIPMENT**

(30) Priority: 28.12.2020 CN 202011575631
(71) Applicant: Jiangsu Favored Nanotechnology Co., Ltd., Wuxi, Jiangsu 214000 (CN)
(72) Inventor: ZONG, Jian, Wuxi, Jiangsu 214000 (CN); WANG, Zhijun, Wuxi, Jiangsu 214000 (CN)
(74) Representative: Mewburn Ellis LLP
(86) International application number: PCT/CN2021/134978
(87) International publication number: WO 2022/142990

(57) **Abstract**

An exhaust gas filtering apparatus (1) and coating equipment (1000). The exhaust gas filtering apparatus (1) comprises at least one filtering unit (20), a first mounting unit (11), and a second mounting unit (12), where the filtering unit (20) is convenient to replace and can be replaced in a timely manner. The coating equipment (1000) comprises a coating body (2) and the exhaust gas filtering apparatus (1), where the coating body (2) is provided with a coating compartment (300), and a gas inlet (101) of the exhaust gas filtering apparatus (1) is in communication with the coating compartment (300).

## Description

### TECHNICAL FIELD

The present disclosure relates to the field of exhaust gas treatment, and particularly, to an exhaust gas filtering apparatus and a coating equipment.

### BACKGROUND

During the coating process, reactive raw materials are introduced into a reaction chamber to carry out a reaction. And, part of unreacted raw materials and part of side product(s) generated by the reaction will form exhaust gas, which needs to be discharged in time from the reaction chamber to enable the pressure in the reaction chamber to be within a controlled range, and will generally cause damage to the environment if being discharged directly.

Usually, the exhaust gas is absorbed by disposing a filter flask at the outlet. The filter flask has a filter material placed therein, and will be replaced with a new one when the exhaust gas treatment capacity thereof is about to reach the upper limit. For a coating equipment, the reaction chamber thereof needs to be maintained at a relatively low-pressure state relative to the normal atmospheric pressure environment outside, in order to facilitate the coating reaction. Therefore, when replacing the filter flask, it is often necessary to stop the operation of the coating equipment, so as to, on the one hand, prevent the exhaust gas from being discharged to the outside, and on the other hand, avoid external air entering the reaction chamber to affect the coating environment.

There are two ways to replace the filter flask, one is to simply replace the filter material therein, and the other is to replace both the filter material and the filter flask. Due to the higher cost of the latter and the possibility of adjusting anew the connection between a new filter flask and the reaction chamber to ensure sealability after replacing with the new filter flask, the former is more commonly applied.

In the process of actual use, it is found that there are two more problems with using a filter flask for filtration. One problem is decrease in production efficiency caused by shutdown. The service life of the filter flask is about one week, which means the coating equipment has to be shut down once a week. The other problem is that the filter flask has a small gas flow diameter and thus a large pressure drop, which leads to frequent alarms from a vacuum pump with a low back pressure requirement.

### SUMMARY

One advantage of the present disclosure is to provide an exhaust gas filtering apparatus and a coating equipment, wherein the exhaust gas filtering apparatus is able to be quickly replaced when needed, to minimize the influence on the work efficiency of the coating equipment.

Another advantage of the present disclosure is to provide an exhaust gas filtering apparatus and a coating equipment, wherein the exhaust gas filtering apparatus is able to provide a relatively large gas flow diameter to reduce the pressure drop.

Still another advantage of the present disclosure is to provide an exhaust gas filtering apparatus and a coating equipment, wherein a filtering unit of the exhaust gas filtering apparatus is able to be detached and installed conveniently, and the sealability of a new filtering unit is able to be ensured.

Yet another advantage of the present disclosure is to provide an exhaust gas filtering apparatus and a coating equipment, wherein the exhaust gas filtering apparatus includes a monitoring unit capable of monitoring the filtering unit to prompt timely replacement of the filtering unit.

According to one aspect of the present disclosure, what provided is an exhaust gas filtering apparatus, which includes:
a first mounting unit;
a second mounting unit; and
at least one filtering unit,
and has an air outlet, an air inlet, and a gas channel,
wherein the second mounting unit is communicated with the air inlet, the first mounting unit is communicated with the air outlet, and the filtering unit is located between the second mounting unit and the first mounting unit which are respectively detachably installed thereon, and wherein one of the filtering units has a first mounting side where the second mounting unit is located and a second mounting side where the first mounting unit is located, and the exhaust gas is adapted to be guided into the second mounting unit from the air inlet, then through the filtering unit from the first mounting side and to move towards the second mounting side, and finally, sequentially through the first mounting unit and the air outlet to leave the exhaust gas filtering apparatus.

According to an embodiment of the present disclosure, the filtering unit has a filtering inlet and a filtering outlet, and the first mounting unit has an mounting opening, wherein the exhaust gas filtering apparatus further includes an mounting component, which includes a mounting part provided to the first mounting unit and a mounting accessory provided to the filtering unit, and by means of detachable connection between the mounting part and the mounting accessory, the filtering unit and the first mounting unit are detachably installed in a manner that the filtering outlet is aligned with the mounting opening of the first mounting unit.

According to an embodiment of the present disclosure, the filtering unit is of at least two in number, each of which has a filtering inlet and a filtering outlet, wherein the exhaust gas filtering apparatus further includes a mounting component, which includes a mounting part provided to one of the filtering units and a mounting accessory provided to an adjacent filtering unit to the one, and by means of detachable connection between the mounting part and the mounting accessory, the adjacent two filtering units are detachably installed in a manner that the filtering inlet is aligned with the filtering outlet.

According to an embodiment of the present disclosure, the mounting part is implemented as a hook, the mounting accessory is provided as a permanent seat formed by extending outward from the peripheral position where the filtering outlet is formed of the filtering unit, and the mounting part is adapted to be detachably hung on the permanent seat; alternatively, wherein the mounting part is implemented as a screw, the mounting accessory is implemented as a mounting hole, and the mounting part is adapted to be detachably screwed to the mounting accessory; alternatively, wherein the mounting part is implemented as a flippable buckle, the mounting accessory is provided as a permanent seat, and the mounting part is adapted to be detachably buckled onto the permanent seat.

According to an embodiment of the present disclosure, the exhaust gas filtering apparatus further includes a monitoring unit, which is communicated with the gas channel and provided behind the filtering unit, so as to allow the exhaust gas to pass through the filtering unit first and then through the monitoring unit.

According to an embodiment of the present disclosure, the monitoring unit is provided with an observation window and includes an indicating module, and by means of observing whether the indicating module is ineffective through the observation window, it is determined whether the filtering unit needs to be replaced.

According to an embodiment of the present disclosure, the monitoring unit includes a detecting module, an indicating module, and a processing module, wherein the processing module is communicatively connected to the detecting module and the indicating module, respectively, the detecting module is used to detect exhaust gas filtered by the filtering unit, and based on a detection result of the detecting module, the processing module predetermines a replacement time of the filtering unit and sends a signal to the indicating module, which then sends an instruction to prompt the replacement of the filtering unit.

According to an embodiment of the present disclosure, the second mounting unit is located below the first mounting unit, and has a liquid outlet formed therein, which is configured near a pooled liquid condensed from cooled exhaust gas and to be adapted to discharge the pooled liquid in situ.

According to an embodiment of the present disclosure, the exhaust gas filtering apparatus includes a sealing ring adapted to be detachably installed between the filtering unit and the first mounting unit to ensure sealability between the filtering unit and the first mounting unit.

According to another aspect of the present disclosure, what provided is an exhaust gas filtering apparatus, which includes at least three filtering units and has an air outlet, an air inlet, and a gas channel, wherein the air outlet, the air inlet, and the gas channel are interconnected and the gas channel is formed in the filtering unit, and wherein the filtering unit has a filtering inlet, a filtering outlet, and a filtering chamber, the filtering inlet and filtering outlet of one of the filtering units are respectively aligned with the filtering outlet of one adjacent filtering unit and the filtering inlet of another adjacent filtering unit, and are detachably lying transversely between the two filtering units, and the exhaust gas is adapted to be guided into one of the filtering units from the air inlet, sequentially through a plurality of filtering units, and finally, through the air outlet to leave the exhaust gas filtering apparatus.

According to still another aspect of the present disclosure, what provided is a coating equipment, which includes:
a coating body having a coating chamber; and
an exhaust gas filtering apparatus which includes:
a first mounting unit;
a second mounting unit; and
at least one filtering unit,
and has an air outlet, an air inlet, and a gas channel,
wherein the second mounting unit is communicated with the air inlet, the air inlet is communicated with the coating chamber of the coating body, the first mounting unit is communicated with the air outlet, and the filtering unit is located between the second mounting unit and the first mounting unit which are respectively detachably installed thereon, and wherein one of the filtering units has a first mounting side where the second mounting unit is located and a second mounting side where the first mounting unit is located, and the exhaust gas is adapted to be guided into the second mounting unit from the air inlet, then through the filtering unit from the first mounting side and to move towards the second mounting side, and finally, sequentially through the first mounting unit and the air outlet to leave the exhaust gas filtering apparatus.

According to yet another aspect of the present disclosure, what provided is a coating equipment, which includes:
a coating body having a coating chamber; and
an exhaust gas filtering apparatus which includes at least three filtering units and has an air outlet, an air inlet, and a gas channel, wherein the air outlet, the air inlet, and the gas channel are interconnected and the air inlet is communicated with the coating chamber of the coating body, and wherein the filtering unit has a filtering inlet, a filtering outlet, and a filtering chamber, the filtering inlet and filtering outlet of one of the filtering units are respectively aligned with the filtering outlet of one adjacent filtering unit and the filtering inlet of another adjacent filtering unit, and are detachably lying transversely between the two filtering units, and the exhaust gas is adapted to be guided into one of the filtering units from the air inlet, sequentially through a plurality of filtering units, and finally, through the air outlet to leave the exhaust gas filtering apparatus.

### BRIEF DESCRIPTION OF THE DRAWINGS

FIG. 1 is a schematic view of an exhaust gas filtering apparatus according to a preferred embodiment of the present disclosure.
FIG. 2 is a schematic cutaway view of the above exhaust gas filtering apparatus according to the present disclosure.
FIG. 3 is a schematic exploded view of the above exhaust gas filtering apparatus according to the present disclosure.
FIG. 4 is a schematic view of a filtering unit of the above exhaust gas filtering apparatus according to the present disclosure.
FIGS 5A and 5B are schematic views of replacement processes of the above filtering unit of the exhaust gas filtering apparatus according to the present disclosure.
FIG. 6 is a schematic view of an exhaust gas filtering apparatus according to another preferred embodiment of the present disclosure.
FIG. 7 is a schematic view of an exhaust gas filtering apparatus according to still another preferred embodiment of the present disclosure.

### DETAILED DESCRIPTION

The following description serves to disclose the present disclosure, in order to enable one skilled in the art to realize the present disclosure. Preferred embodiments in the following description are given by way of example only, and other obvious variations will occur to those skilled in the art. The basic principles of the present disclosure defined in the following description may be applied to other embodiments, variations, modifications, equivalents, and other technical solutions without departing from the spirit and scope of the present disclosure.

It should be appreciated by those skilled in the art that, in the context of the present disclosure, the orientation or positional relationships indicated by the terms "longitudinal", "transverse", "upper", "lower", "front", "back", "left", "right", "vertical", "horizontal", "top", "bottom", "inner", "outer", etc. are based on those illustrated in the FIGS.. In addition, these terms are merely for convenience in describing the present disclosure and to simplify the description, rather than to indicate or imply that the apparatus or element referred to must have a particular orientation or be constructed and operated in a particular orientation, and thus the above terms should not be construed as limiting the present disclosure.

It should be understood that, the term "a" or "an" should be interpreted as "at least one" or "one or more", that is, in one embodiment, the number of an element may be one, and in another embodiment, the number of the element may be plural, and the term "a" or "an" should not be construed as a limitation on the number.

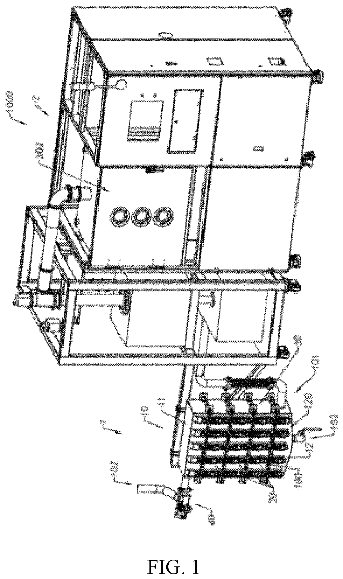

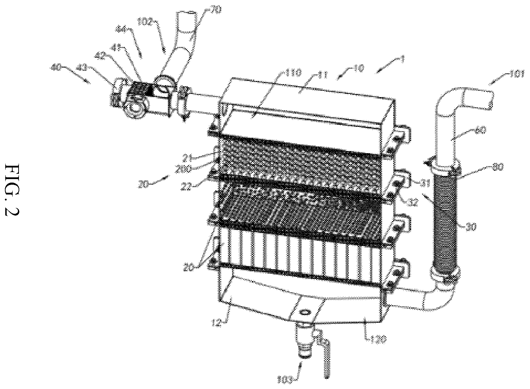

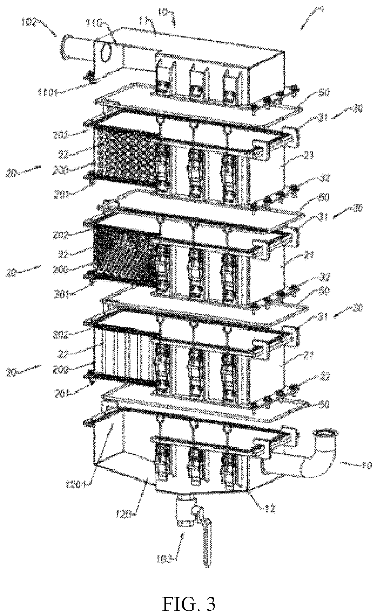

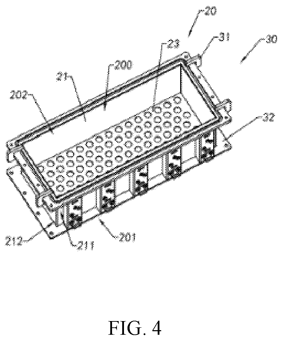

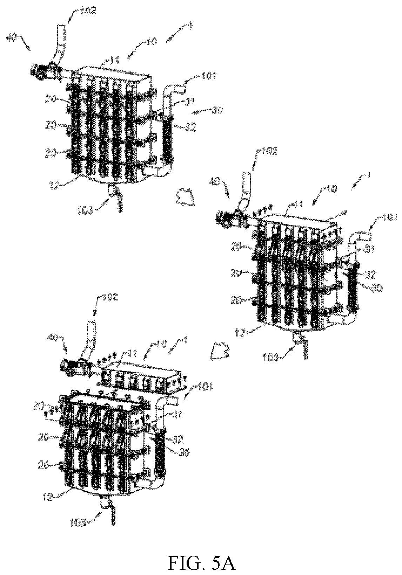

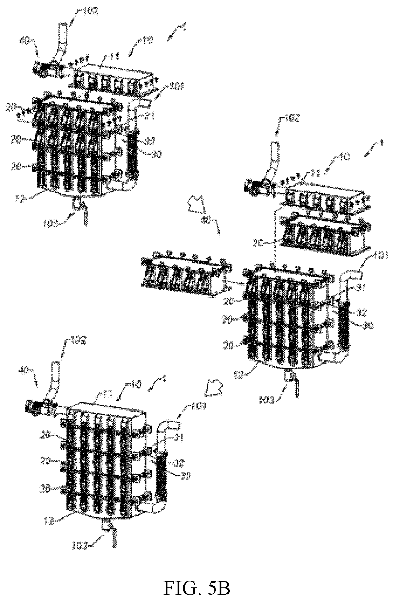

Referring to FIGS. 1 to 5B, an exhaust gas filtering apparatus 1 and a coating equipment 1000 according to a preferred embodiment of the present disclosure are illustrated.

The exhaust gas filtering apparatus 1 is able to be used in conjunction with a coating body 2 of the coating equipment 1000. The coating body 2 of the coating equipment 1000 needs to discharge exhaust gas during operation, and the exhaust gas is guided through the exhaust gas filtering apparatus 1 to make the treated exhaust gas adapted for direct discharge towards the surrounding environment.

The exhaust gas filtering apparatus 1 has an air inlet 101 and an air outlet 102, wherein the air inlet 101 is communicated with a coating chamber 300 of the coating body 2 of the coating equipment 1000, and the air outlet 102 is communicated with the external environment. The exhaust gas filtering apparatus 1 has a gas channel 100, wherein the air inlet 101 and the air outlet 102 are respectively located at two ends and communicated with the gas channel 100.

The exhaust gas filtering apparatus 1 may include a mounting housing 10 and at least one filtering unit 20, wherein the filtering unit 20 may be detachably installed on the mounting housing 10. The mounting housing 10 may include a first mounting unit 11 and a second mounting unit 12, wherein the air inlet 101 is provided on the second mounting unit 12 of the mounting housing 10, and the air outlet 102 is provided on the first mounting unit 11 of the mounting housing 10. The filtering unit 20 is installed between the second mounting unit 12 and the first mounting unit 11. The gas channel 100 is formed in the second mounting unit 12, the first mounting unit 11, and the filtering unit 20. The exhaust gas from the reaction chamber sequentially passes through the air inlet 101, the second mounting unit 12, the filtering unit 20, the first mounting unit 11, and the air outlet 102.

One of the filtering units 20 is detachably installed on the second mounting unit 12, one of the filtering units 20 is detachably installed on the first mounting unit 11, so that the filtering unit(s) 20 may be detached directly from the second mounting unit 12 and/or the first mounting unit 1 1 when the filtering unit(s) 20 needs to be replaced.

Specifically, the filtering unit 20 has a first mounting side and a second mounting side. When the number of the filtering unit 20 is one, the second mounting unit 12 is provided on a side of the first mounting side of the filtering unit 20, and the first mounting unit 11 is provided on a side of the second mounting side of the same filtering unit 20. When the number of the filtering unit 20 is two or more, the second mounting unit 12 is provided on a side of the first mounting side of one filtering unit 20, and the first mounting unit 11 is provided on a side of the second mounting side of another filtering unit 20. The first and second mounting sides of the filtering unit 20 may be two opposite or adjacent sides.

The filtering unit 20 is lying transversely between the second mounting unit 12 and the first mounting unit 11, and the exhaust gas is guided along the first mounting side of the filtering unit 20 towards the second mounting side to through the filtering unit 20 to be filtered.

In this way, the exhaust gas is able to pass through a position with a relatively large cross-sectional area of the filtering unit 20, which is beneficial for improving the work efficiency of the exhaust gas filtering apparatus 1.

More specifically, the filtering unit 20 includes a side wall 21 and has a filtering chamber 200, wherein the side wall 21 surrounds to form the filtering chamber 200. The side wall 21 has a high end 211 and a low end 212, wherein the first mounting side is located at the high end 211 of the side wall 21, and the second mounting side is located at the low end 212 of the side wall 21. The filtering unit 20 further includes a filter material 22, wherein the filter material 22 is provided on the side wall 21 and located in the filtering chamber 200. Type of the filter material 22 may be selected according to needs, may be, but is not limited to, activated carbon filter material 22, or aluminium oxide filter material 22, or the like.

When the number of the filtering unit 20 is two or more, adjacent filtering units 20 may be mounted detachably to each other, so as to facilitate the convenient replacement of one of the filtering units 20 when it needs to be replaced. In other words, when the number of the filtering unit 20 is two or more, all the filtering units 20 may be detached as a whole for replacement, or alternatively, an expectant filtering unit 20 may be detached individually.

The filtering unit 20, installed adjacently to the second mounting unit 12 or the first mounting unit 11, is also detachably installed on the second mounting unit 12 or the first mounting unit 11 for easy replacement. Specifically, the exhaust gas filtering apparatus 1 further includes at least one mounting component 30 adapted to connect the second mounting unit 12 and the filtering unit 20, or one filtering unit 20 and an adjacent filtering unit 20, or the first mounting unit 11 and the filtering unit 20. The mounting component 30 includes a mounting part 31 and a mounting accessory 32, wherein the mounting part 31 is detachably installed on the mounting accessory 32, the mounting part 31 or the mounting accessory 32 is adapted to be installed on the second mounting unit 12, and the mounting accessory 32 or the mounting part 31 is adapted to be installed on the first mounting unit 11, so as to enable detachable mounting between two components on which the mounting part 31 and the mounting accessory 32 are respectively installed.

The mounting part 31 or the mounting accessory 32 of the mounting component 30 may be provided at the peripheral position of the side wall 21 or on the side wall 21 of the filtering unit 20, or at the peripheral position or side wall of the second mounting unit 12 and the first mounting unit 11. When the filtering unit 20 is mounted onto another filtering unit 20, oppositely provided mounting parts 31 may be mounted on the mounting accessory 32 to limit displacement of two filtering units 20, so as to avoid the two filtering units 20 separate from each other. Alternatively, when the filtering unit 20 is mounted onto the second mounting unit 12, oppositely provided mounting parts 31 may be mounted on the mounting accessory 32 to limit displacement of the filtering unit 20 and the second mounting unit 12, so that the filtering unit 20 and the second mounting unit 12 are securely mounted and connected. Alternatively, when the filtering unit 20 is mounted onto the first mounting unit 11, oppositely provided mounting parts 31 may be mounted on the mounting accessory 32 to limit displacement of the filtering unit 20 and the first mounting unit 11, so that the filtering unit 20 and the first mounting unit 11 are securely mounted and connected.

The mounting part 31 and the mounting accessory 32 of the mounting component 30 may be provided in a form of buckles matching with each other, may be plural in number, and may be different in type.

According to this embodiment, a type of mounting part 31 and mounting accessory 32 are implemented as a permanent seat and a flippable buckle. When the mounting part 31 and the mounting accessory 32 need to be detached, the buckle is flipped in a direction away from the permanent seat, so that the permanent seat and the buckle are separated from each other. When the mounting part 31 and the mounting accessory 32 need to be fixedly connected, the buckle is flipped towards the direction of the permanent seat, so that the buckle snaps into the permanent seat. Another type of mounting part 31 and mounting accessory 32 are implemented as a permanent seat and a hook, respectively. When the mounting part 31 and the mounting accessory 32 move in a predetermined direction to make the hook engage with the permanent seat, the filtering unit 20 on which the mounting part 31 is mounted and the filtering unit 20 on which the mounting accessory 32 is mounted may be locked with each other. When the mounting part 31 and the mounting accessory 32 move back in a predetermined direction to separate the hook from the permanent seat, the filtering unit 20 on which the mounting part 31 is mounted and the filtering unit 20 on which the mounting accessory 32 is mounted may be unlocked with each other.

According to this embodiment, both the above two types of mounting parts 31 and mounting accessories 32 are used, and explanation is provided with the installation of two filtering units 20 as an example. When one filtering unit 20 is located below the other filtering unit 20, and the two filtering units 20 are misaligned with each other, one mounting part 31 may be located on the second mounting side of one filtering unit 20, one mounting accessory 32 may be located on the first mounting side of the other filtering unit 20, and the mounting part 31 and the mounting accessory 32 are able to be aligned with each other, so that the mounting part 31 may be engaged with the mounting accessory 32 during the process of aligning the two filtering units 20 with each other. After the two filtering units 20 are aligned with each other, the mounting accessory 32, implemented as a flippable buckle on the side of one filtering unit 20, is flipped to be engaged with the mounting part 31 on the side of the other filtering unit 20.

Furthermore, in order to make the mounting between two filtering units 20, or between one filtering unit 20 and the second mounting unit 12, or between one filtering unit 20 and the first mounting unit 11 more stable, the mounting component 30 may further include another set of mounting part 31 and mounting accessory 32, wherein the mounting part 31 may be implemented as a bolt, the mounting accessory 32 may be implemented as a mounting hole, and after one filtering unit 20 is aligned and mounted on another filtering unit 20, or after the filtering unit 20 is aligned and mounted on the second mounting unit 12 or the first mounting unit 11, the mounting part 31 and the mounting accessory 32 are screwed, so as to fasten the adjacent filtering units 20, or fasten the filtering unit 20 and the second mounting unit 12 or the first mounting unit 11.

Furthermore, the second mounting unit 12 and/or the first mounting unit 11 of the exhaust gas filtering apparatus 1 may be fixedly provided on the coating equipment 1000, so that the filtering unit 20 may be mounted on the coating equipment 1000 through mounting between the filtering unit 20 and the second mounting unit 12 and/or the first mounting unit 11.

The first mounting unit 11 may be located below the second mounting unit 12. The air inlet 101 is located on a side of the first mounting unit 11. The air outlet 102 is located on a side of the second mounting unit 12. The gas channel 100 extends from the air inlet 101 from bottom to top to the air outlet 102.

Furthermore, the exhaust gas filtering apparatus 1 may include a monitoring unit 40, wherein the monitoring unit 40 may be used to monitor the effectiveness of the filtering unit 20. The monitoring unit 40 may be located behind the filtering unit 20 to allow exhaust gas to pass through the monitoring unit 40 after being treated by the filtering unit 20.

The monitoring unit 40 may include at least one detecting module 41 and at least one indicating module 42, wherein the detecting module 41 is provided in the gas channel 100 and behind the filtering unit 20, so as to allow exhaust gas to pass through the detecting module 41 after being filtered by the filtering unit 20. The detecting module 41 is used to detect a specific substance in the exhaust gas. When the detecting module 41 detects the specific substance in the exhaust gas exceeds a certain amount, the indicating module 42 may give an indication. The detecting module 41 and the indicating module 42 may be the same substance, such as a type of reagent that may chemically react with the specific substance in the exhaust gas and indicate by discoloration.

As an example, one filtering unit 20 is used to filter a harmful gas A in the exhaust gas. After being filtered by the filtering unit 20, the harmful gas A in the exhaust gas has been removed or below a certain content. However, if the harmful gas A or more than the certain content of the harmful gas A is detected through the detecting module 41, and the indicating module 42 gives a relevant indication, it demonstrates that, the filter material 22 in the corresponding filtering unit 20 has been ineffective and needs to be replaced.

It should be understood that, the number of the detecting module 41 and the indicating module 42 may be set according to the requirements, for example, when the number of the filtering unit 20 is two or more, and the filter materials 22 inside the filtering units 20 are not the same, one detecting module 41 and one indicating module 42 may be used to indicate whether the corresponding filtering unit 20 is ineffective.

In addition, according to this embodiment, the detecting module 41 is provided at the position of the air outlet 102, and the filtered exhaust gas is discharged outward after passing through the detecting module 41. In this way, the detachment and mounting of the filtering unit 20 relative to the second mounting unit 12 or the first mounting unit 11 do not affect the detecting module 41 and the indicating module 42. It should be understood that, the detecting module 41 and the indicating module 42 may also be detachably mounted at the position of the air outlet 102, respectively, to facilitate the replacement of the detecting module 41 and the indicating module 42.

Furthermore, a user may determine whether the filtering unit 20 needs to be replaced by directly observing the monitoring unit 40. Alternatively, the monitoring unit 40 may be a communicable equipment that may send information to another electronic equipment, such as, a production management equipment, a mobile electronic equipment, etc., to prompt the user to replace the equipment in time.

Optionally, the monitoring unit 40 may further include a processing module 43, wherein the detecting module 41 is communicatively connected to the processing module 43, and the indicating module 42 may be communicatively connected to the processing module 43.

The processing module 43 is able to predetermine whether the filtering unit 20 is about to be ineffective based on the data detected by the detecting module 41. The indicating module 42 is able to give an indication in advance to reduce the possibility of exhaust gas not meeting environmental protection requirements being discharged outward.

For example, based on the data detected by the detecting module 41, the amount of a substance that does not meet environmental requirements in the exhaust gas increased by 10% from ten to twenty past nine, and that increased by 50% from twenty to half past nine. According to this growth law, the content of the substance is highly likely to have exceeded the preset value by nine forty, the processing module 43 sends an instruction to the indicating module 42, which may send a prompt in advance before nine forty.

According to this embodiment, the monitoring unit 40 is implemented to include aluminium oxide treated with a special chemical reagent, which indicates whether the filter material 22 in the filtering unit 20 is ineffective through a change in color. The monitoring unit 40 may form an observation window 44, so that a user may observe the color change of the aluminum oxide inside the monitoring unit 40 through the observation window 44.

Furthermore, the first mounting unit 11 forms a first accommodating chamber 110 communicated with the filtering chamber 200 of the filtering unit 20 and the air outlet 102. The exhaust gas passed through the filtering unit 20 converges at the first mounting unit 11, then leaves the first mounting unit 11 through the air outlet 102, and thereafter, passes through the detecting module 41 and the indicating module 42.

The second mounting unit 12 forms a second accommodating chamber 120 communicated with the filtering chamber 200 of the filtering unit 20 and the air inlet 101. The exhaust gas from the air inlet 101 converges at the position of the second accommodating chamber 120 of the second mounting unit 12 and enters the filtering unit 20 upwards.

The exhaust gas filtering apparatus 1 has a liquid outlet 103, wherein the liquid outlet 103 is provided on and at a lower position of the second mounting unit 12, so that the liquid condensed on the inner wall of the second mounting unit 12 or at the filtering unit 20 located above the second mounting unit 12 is able to be discharged through the liquid outlet 103, to avoid gathering at the second mounting unit 12 to affect the passage of the exhaust gas.

It should be understood that, the temperature of the exhaust gas from the coating equipment 1000 may be at a higher level than the ambient temperature of the exhaust gas filtering apparatus 1. Therefore, when the exhaust gas contains moisture therein, it will condense into a liquid when encountering the inner wall of the second mounting unit 12 or the filtering unit 20, and move towards the position of the liquid outlet 103 under the action of gravity. The liquid outlet 103 is configured to be openable or closable, for example, may be provided with a valve to discharge condensate regularly.

Furthermore, in order to ensure the sealability of the connection between two adjacent detachable filtering units 20 and prevent exhaust gas leakage, or to ensure the sealability of the connection between the filtering unit 20 and the second mounting unit 12, or to maintain the sealability of the connection between the filtering unit 20 and the first mounting unit 11, the exhaust gas filtering apparatus 1 further includes at least one sealing ring 50 provided between the filtering unit 20 and the filtering unit 20, or between the filtering unit 20 and the second mounting unit 12, or between the filtering unit 20 and the first mounting unit 11. The sealing ring 50 may be detachably installed. The sealing ring 50 is provided at the connection edge position between the filtering unit 20 and the filtering unit 20, or at the connection edge position between the filtering unit 20 and the second mounting unit 12, or at the connection edge position between the filtering unit 20 and the first mounting unit 11.

Specifically, the filtering unit 20 has a filtering inlet 201 and a filtering outlet 202 respectively located on two sides of and communicated with the filtering chamber 200, wherein the sealing ring 50 is provided at the position of the side wall 21 forming the filtering inlet 201 or at the position of the side wall 21 forming the filtering outlet 202. The first mounting unit 11 is provided on the side of the filtering outlet 202 of the filtering unit 20. The second mounting unit 12 is provided on the side of the filtering inlet 201 of the filtering unit 20.

The cross-section of the filtering unit 20 may be, but is not limited to, a rectangle, a circle, or a polygon. The shape of the filtering inlet 201 of one filtering unit 20 and the shape of the filtering outlet 202 of the other filtering unit 20 match each other to facilitate sealability between the two. Alternatively, the shape of the filtering outlet 202 of one filtering unit 20 and the shape of a mounting opening 1101 of the first mounting unit 11 match each other to facilitate the sealability between the two. Alternatively, the shape of the filtering inlet 201 of one filtering unit 20 and the shape of a mounting opening 1201 of the second mounting unit 12 match each other to facilitate the sealability between the two.

The exhaust gas filtering apparatus 1 may also include an air inlet pipe 60 and an air outlet pipe 70 respectively provided at the position of the air inlet 101 and of the air outlet 102, wherein the air inlet pipe 60 is adapted to communicate the coating equipment 1000 with the second mounting unit 12, and the air outlet pipe 70 is adapted to communicate an external discharge equipment and the first mounting unit 11.

The exhaust gas filtering apparatus 1 may further include a corrugated pipe 80 provided between the air inlet pipe 60 and the second mounting unit 12. The exhaust gas is transported from top to bottom through the air inlet pipe 60 and the corrugated pipe 80 to the position of the air inlet 101, and then, passes through the filtering unit 20 from bottom to top to be filtered, and thereafter, leaves through the air outlet pipe 70.

According to this embodiment, the filtering units 20 has a number of three, which are respectively implemented from top to bottom as an aluminium monoxide filter box, an activated carbon filter box, and a honeycomb activated carbon filter box, that is, the exhaust gas sequentially passes through the honeycomb activated carbon filter box, the activated carbon filter box, and the aluminium monoxide filter box. Furthermore, the filter material 22 may further include an activated carbon sponge provided at the positions of the filtering inlet 201 and the filtering outlet 202 of the filtering unit 20, which may prevent a pollutant with a relatively large particle from on the one hand, entering the filtering chamber 200, and on the other hand, leaving the filtering chamber 200.

The filtering unit 20 further includes at least one carrier plate 23, wherein the carrier plate 23 is supported on the side wall 21 and is provided as hollow to enable the exhaust gas to pass smoothly, and the filter material 22 may be supported on the carrier plate 23. It should be understood that, the type and construction of the filter material 22 may be selected according to needs. The types of filter materials 22 within the same filtering unit 20 may be different. The filter material 22 may have a gap formed inside to facilitate the passage of exhaust gas.

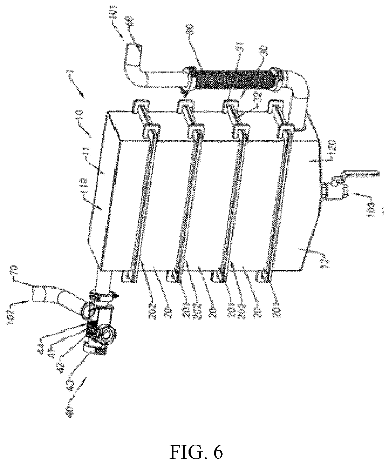

Referring to FIG. 6, which illustrates an exhaust gas filtering apparatus 1 according to another preferred embodiment of the present disclosure.

According to this embodiment, the mounting component 30 of the exhaust gas filtering apparatus 1 is implemented as a hook type. The mounting between two filtering units 20 is explained as an example. The side wall 21 forming the filtering inlet 201 part of the filtering unit 20 extends outward to form a permanent seat as the mounting part 31 of the mounting component 30, and another filtering unit 20 is provided with the mounting accessory 32 near the filtering outlet 202. The mounting of the two filtering units 20 may be achieved by directly hanging the mounting accessory 32 onto the mounting part 31.

Specifically, the mounting part 31 is hung on the mounting accessory 32, when aligning the filtering inlet 201 of one filtering unit 20 with the filtering outlet 202 of another filtering unit 20, and gradually aligning the mounting part 31 with the mounting accessory 32, so that the position of the filtering inlet 201 fits that of the filtering outlet 202.

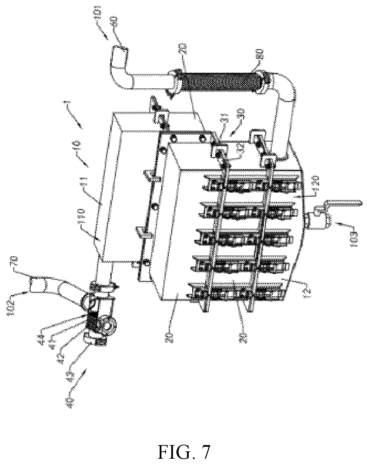

Referring to Figure 7, which illustrates an exhaust gas filtering apparatus 1 according to still another preferred embodiment of the present disclosure.

According to the above embodiment, the mounting housing 10 and the filtering unit 20 in the exhaust gas filtering apparatus 1 are provided in the same direction, such as in a vertical direction. The second mounting unit 12 and the first mounting unit 11 of the mounting housing 10 are respectively located on the opposite first mounting side and second mounting side of the filtering unit 20.

According to this embodiment, the second mounting unit 12 and the first mounting unit 11 of the mounting housing 10 in the exhaust gas filtering apparatus 1 are located on adjacent two sides of the filtering unit 20, respectively. The relative positions of the mounting housing 10 and the filtering unit 20, or of a plurality of filtering units 20, may be arranged according to the requirements of the gas channel 100.

It should be understood that, the filtering unit 20 may be connected directly to the air inlet pipe 60 and the air outlet pipe 70, that is, the exhaust gas filtering apparatus 1 may not include the mounting housing 10. For example, the filtering unit 20 may have a number of three, and the filtering unit 20 located in the middle is detachably connected to the adjacent two filtering units 20, respectively, so that it is replaceable.

It should be understood by those skilled in the art that, the embodiments of the present disclosure shown in the above description and the accompanying drawings are only examples and do not limit the present disclosure. The objects of the present disclosure have been fully and effectively achieved. The functional and structural principles of the present disclosure have been shown and explained in the embodiments, and any variations or modifications of the embodiments of the present disclosure are possible without departing from the principles.

## Claims

1. An exhaust gas filtering apparatus, **characterized by** comprising:
a first mounting unit;
a second mounting unit; and
at least one filtering unit,
and having an air outlet, an air inlet, and a gas channel,
wherein the second mounting unit is communicated with the air inlet, the first mounting unit is communicated with the air outlet, and the filtering unit is located between the second mounting unit and the first mounting unit which are respectively detachably installed on the filtering unit, and wherein one of the filtering units has a first mounting side where the second mounting unit is located and a second mounting side where the first mounting unit is located, and an exhaust gas is adapted to be guided into the second mounting unit from the air inlet, then through the filtering unit from the first mounting side and to move towards the second mounting side, and finally, sequentially through the first mounting unit and the air outlet to leave the exhaust gas filtering apparatus.

2. The exhaust gas filtering apparatus according to claim 1, **characterized in that** the filtering unit has a filtering inlet and a filtering outlet, and the first mounting unit has an mounting opening, wherein the exhaust gas filtering apparatus further comprises an mounting component, which comprises a mounting part provided to the first mounting unit and a mounting accessory provided to the filtering unit, and by means of detachable connection between the mounting part and the mounting accessory, the filtering unit and the first mounting unit are detachably installed in a manner that the filtering outlet is aligned with the mounting opening of the first mounting unit.

3. The exhaust gas filtering apparatus according to claim 1, **characterized in that** the filtering unit is of at least two in number, each of the filtering units has a filtering inlet and a filtering outlet, wherein the exhaust gas filtering apparatus further comprises a mounting component, which comprises a mounting part provided to one of the filtering units and a mounting accessory provided to an adjacent filtering unit to the one, and by means of detachable connection between the mounting part and the mounting accessory, the adjacent two filtering units are detachably installed in a manner that the filtering inlet is aligned with the filtering outlet.

4. The exhaust gas filtering apparatus according to claim 2 or 3, **characterized in that** the mounting part is implemented as a hook, the mounting accessory is provided as a permanent seat formed by extending outward from the peripheral position where the filtering outlet is formed of the filtering unit, and the mounting part is adapted to be detachably hung on the permanent seat; alternatively, wherein the mounting part is implemented as a screw, the mounting accessory is implemented as a mounting hole, and the mounting part is adapted to be detachably screwed to the mounting accessory; alternatively, wherein the mounting part is implemented as a flippable buckle, the mounting accessory is provided as a permanent seat, and the mounting part is adapted to be detachably buckled onto the permanent seat.

5. The exhaust gas filtering apparatus according to any one of claims 1 to 3, **characterized in that** the exhaust gas filtering apparatus further comprises a monitoring unit, which is communicated with the gas channel and provided behind the filtering unit, so as to allow the exhaust gas to pass through the filtering unit first and then through the monitoring unit.

6. The exhaust gas filtering apparatus according to claim 5, **characterized in that** the monitoring unit is provided with an observation window and comprises an indicating module, and by means of observing whether the indicating module is ineffective through the observation window, it is determined whether the filtering unit needs to be replaced.

7. The exhaust gas filtering apparatus according to claim 5, **characterized in that** the monitoring unit comprises a detecting module, an indicating module, and a processing module, wherein the processing module is communicatively connected to the detecting module and the indicating module, respectively, the detecting module is used to detect the exhaust gas filtered by the filtering unit, and based on a detection result of the detecting module, the processing module predetermines a replacement time of the filtering unit and sends a signal to the indicating module, which then sends an instruction to prompt the replacement of the filtering unit.

8. The exhaust gas filtering apparatus according to any one of claims 1 to 3, **characterized in that** the second mounting unit is located below the first mounting unit, and has a liquid outlet formed therein, the liquid outlet is configured near a pooled liquid condensed from cooled exhaust gas and to be adapted to discharge the pooled liquid in situ.

9. The exhaust gas filtering apparatus according to any one of claims 1 to 3, **characterized in that** the exhaust gas filtering apparatus comprises a sealing ring adapted to be detachably installed between the filtering unit and the first mounting unit to ensure sealability between the filtering unit and the first mounting unit.

10. An exhaust gas filtering apparatus, **characterized by** comprising at least three filtering units and having an air outlet, an air inlet, and a gas channel, wherein the air outlet, the air inlet, and the gas channel are interconnected and the gas channel is formed in the filtering unit; and wherein the filtering unit has a filtering inlet, a filtering outlet, and a filtering chamber, the filtering inlet and filtering outlet of one of the filtering units are respectively aligned with the filtering outlet of one adjacent filtering unit and the filtering inlet of another adjacent filtering unit, and are detachably lying transversely between the two filtering units, and the exhaust gas is adapted to be guided into one of the filtering units from the air inlet, sequentially through a plurality of filtering units, and finally, through the air outlet to leave the exhaust gas filtering apparatus.

11. A coating equipment, **characterized by** comprising:
a coating body having a coating chamber; and
an exhaust gas filtering apparatus which comprises:
a first mounting unit;
a second mounting unit; and
at least one filtering unit,
and has an air outlet, an air inlet, and a gas channel,
wherein the second mounting unit is communicated with the air inlet, the air inlet is communicated with the coating chamber of the coating body, the first mounting unit is communicated with the air outlet, and the filtering unit is located between the first mounting unit and the second mounting unit which are respectively detachably installed on the filtering unit, and wherein one of the filtering units has a first mounting side where the second mounting unit is located and a second mounting side where the first mounting unit is located, and an exhaust gas is adapted to be guided into the second mounting unit from the air inlet, then through the filtering unit from the first mounting side and to move towards the second mounting side, and finally, sequentially through the first mounting unit and the air outlet to leave the exhaust gas filtering apparatus.

12. The coating equipment according to claim 11, **characterized in that** the filtering unit has a filtering inlet and a filtering outlet, and the first mounting unit has an mounting opening, wherein the exhaust gas filtering apparatus further comprises an mounting component, which comprises a mounting part provided to the first mounting unit and a mounting accessory provided to the filtering unit, and by means of detachable connection between the mounting part and the mounting accessory, the filtering unit and the first mounting unit are detachably installed in a manner that the filtering outlet is aligned with the mounting opening of the first mounting unit.

13. The coating equipment according to claim 11, **characterized in that** the filtering unit is of at least two in number, each of the filtering units has a filtering inlet and a filtering outlet, wherein the exhaust gas filtering apparatus further comprises a mounting component, which comprises a mounting part provided to one of the filtering units and a mounting accessory provided to an adjacent filtering unit to the one, and by means of detachable connection between the mounting part and the mounting accessory, the adjacent two filtering units are detachably installed in a manner that the filtering inlet is aligned with the filtering outlet.

14. The coating equipment according to claim 12 or 13, **characterized in that** the mounting part is implemented as a hook, the mounting accessory is provided as a permanent seat formed by extending outward from the peripheral position where the filtering outlet is formed of the filtering unit, and the mounting part is adapted to be detachably hung on the permanent seat; alternatively, wherein the mounting part is implemented as a screw, the mounting accessory is implemented as a mounting hole, and the mounting part is adapted to be detachably screwed to the mounting accessory; alternatively, wherein the mounting part is implemented as a flippable buckle, the mounting accessory is provided as a permanent seat, and the mounting part is adapted to be detachably buckled onto the permanent seat.

15. The coating equipment according to any one of claims 11 to 13, **characterized in that** the exhaust gas filtering apparatus further comprises a monitoring unit, which is communicated with the gas channel and provided behind the filtering unit, so as to allow the exhaust gas to pass through the filtering unit first and then through the monitoring unit.

16. The coating equipment according to claim 15, **characterized in that** the monitoring unit is provided with an observation window and comprises an indicating module, and by means of observing whether the indicating module is ineffective through the observation window, it is determined whether the filtering unit needs to be replaced.

17. The coating equipment according to claim 15, **characterized in that** the monitoring unit comprises a detecting module, an indicating module, and a processing module, wherein the processing module is communicatively connected to the detecting module and the indicating module, respectively, the detecting module is used to detect the exhaust gas filtered by the filtering unit, and based on a detection result of the detecting module, the processing module predetermines a replacement time of the filtering unit and sends a signal to the indicating module, which then sends an instruction to prompt the replacement of the filtering unit.

18. The coating equipment according to any one of claims 11 to 13, **characterized in that** the second mounting unit is located below the first mounting unit, and has a liquid outlet formed therein, the liquid outlet is configured near a pooled liquid condensed from cooled exhaust gas and to be adapted to discharge the pooled liquid in situ.

19. The coating equipment according to any one of claims 11 to 13, **characterized in that** the exhaust gas filtering apparatus comprises a sealing ring adapted to be detachably installed between the filtering unit and the first mounting unit to ensure sealability between the filtering unit and the first mounting unit.

20. A coating equipment, **characterized by** comprising:
a coating body having a coating chamber; and
an exhaust gas filtering apparatus which comprises at least three filtering units and has an air outlet, an air inlet, and a gas channel, wherein the air outlet, the air inlet, and the gas channel are interconnected and the air inlet is communicated with the coating chamber of the coating body, and wherein the filtering unit has a filtering inlet, a filtering outlet, and a filtering chamber, the filtering inlet and filtering outlet of one of the filtering units are respectively aligned with the filtering outlet of one adjacent filtering unit and the filtering inlet of another adjacent filtering unit, and are detachably lying transversely between the two filtering units, and the exhaust gas is adapted to be guided into one of the filtering units from the air inlet, sequentially through a plurality of filtering units, and finally, through the air outlet to leave the exhaust gas filtering apparatus.
